(19) Europäisches Patentamt
European Patent Office
Office européen des brevets

(11) Veröffentlichungsnummer: **0 019 122**
**B1**

# (12) EUROPÄISCHE PATENTSCHRIFT

(45) Veröffentlichungstag der Patentschrift: **31.07.85**

(51) Int. Cl.⁴: **G 03 F 7/00**, G 03 C 1/70

(21) Anmeldenummer: **80102259.1**

(22) Anmeldetag: **25.04.80**

## (54) Verfahren zur phototechnischen Herstellung von Reliefstrukturen.

(30) Priorität: **16.05.79 DE 2919841**

(43) Veröffentlichungstag der Anmeldung: **26.11.80 Patentblatt 80/24**

(45) Bekanntmachung des Hinweises auf die Patenterteilung: **31.07.85 Patentblatt 85/31**

(84) Benannte Vertragsstaaten: **AT BE CH DE FR GB IT LI NL SE**

(56) Entgegenhaltungen:
**DE - C - 2 437 348**
**US - A - 3 485 732**
**US - A - 3 871 930**

(73) Patentinhaber: **Siemens Aktiengesellschaft, Berlin und München Wittelsbacherplatz 2, D-8000 München 2 (DE)**

(72) Erfinder: **Rubner, Roland, Dr., Buchenring 15, D-8551 Röttenbach (DE)**
Erfinder: **Kühn, Eberhard, Bergstrasse 32, D-8551 Hemhofen (DE)**
Erfinder: **Ahne, Hellmut, Dr., Heidestrasse 6, D-8551 Röttenbach (DE)**

EP 0 019 122 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur phototechnischen Herstellung von Reliefstrukturen aus Gemischen, welche olefinisch ungesättigte Polymere und Azide als Photoinitiatoren enthalten.

Eines der genauesten Strukturierungsverfahren für Isolierstoffe, Halbleiter- und Leiterwerkstoffe in der Elektrotechnik ist die Phototechnik. Hierbei werden phototechnisch erzeugte Resist-Reliefstrukturen durch geeignete Prozesse, wie Ätzen, Bedampfen und stromloses oder galvanisches Metallisieren, auf Substrate kopiert. Resist-Reliefstrukturen können weiterhin auch eine dauerhafte Schutzfunktion, beispielsweise als Isolierstoff, übernehmen.

Bei einem aus der DE-C-2 437 348 bekannten Verfahren werden Reliefstrukturen aus hochwärmebeständigen Polymeren hergestellt. Dazu werden strahlungsempfindliche lösliche polymere Vorstufen in Form einer Schicht oder Folie auf ein Substrat aufgetragen, die strahlungsempfindliche Schicht oder Folie wird dann durch Negativvorlagen bestrahlt und anschließend werden die nicht bestrahlten Schicht- oder Folienteile vom Substrat entfernt; erforderlichenfalls kann sich hieran noch eine Temperung der erhaltenen Reliefstruktur anschließen. Als lösliche polymere Vorstufen werden bei diesem Verfahren Polyadditions- oder Polykondensationsprodukte polyfunktioneller carbocyclischer oder heterocyclischer, strahlungsempfindliche Reste tragender Verbindungen mit Diaminen, Diisocyanaten, Bissäurechloriden oder Dicarbonsäuren verwendet. Die strahlungsempfindliche Reste tragenden Verbindungen enthalten zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Oxyalkylacrylat- oder -methacrylatgruppen.

Die Lichtempfindlichkeit von Resistmaterialien, wie photoreaktiven Polymeren, kann durch den Zusatz von Photoinitiatoren und Photosensibilisatoren, noch erhöht werden. Dies ist deshalb von Bedeutung, weil für die Wirtschaftlichkeit der phototechnischen Strukturierung von Oberflächen eine möglichst kurze Belegung der teuren Belichtungseinrichtungen, d. h. eine möglichst hohe Empfindlichkeit der verwendeten Photoresists, gefordert wird. Beim bekannten Verfahren werden den polymeren Vorstufen deshalb Verbindungen wie Michlers Keton, d. h. 4,4'-Bis(dimethylamino)-benzophenon, Benzoinäther, 2-tert.Butyl-9,10-anthrachinon, 1,2-Benz-9,10-anthrachinon und Bis(diäthylamino)-benzophenon zugesetzt.

Es ist ferner bereits bekannt, für Resists, insbesondere Negativresists, als Photoinitiatoren Azide zu verwenden. Als Polymere bzw. Prepolymere fanden dabei bislang Diallylphthalat-Prepolymere, Polyisoprenharze und Polyvinylcinnamate Verwendung, d. h. bestimmte olefinisch ungesättigte Polymere (siehe: W. S. DeForest »Photoresist«, McGraw-Hill Book Company, 1975, Seite 35 bis 41). Als Photoinitiatoren wurden bislang im allgemeinen Diazide folgender Struktur eingesetzt:

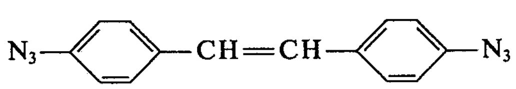

4,4'-Diazidostilben

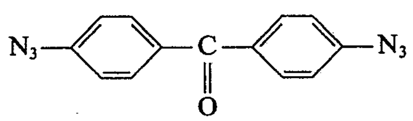

4,4'-Diazidobenzophenon

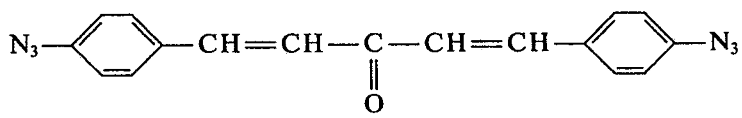

4,4'-Diazidodibenzalaceton

Aus c. A. 84 (1976), 136 481 z, ist die Verwendung von Bis[4-(azidosulfonyl)-phenyl]-uretidindion bei der photolytischen Vernetzung von Polymeren, d. h. Polyurethanen und Poly(vinylpyrrolidon) bekannt. Aus der US-A-3 562 268 ist es bekannt, Tris(azidosulfonylphenyl)-isocyanurate als Vernetzungsagentien in Photoresistsystemen und Elastomeren zu verwenden.

Aufgabe der Erfindung ist es, die Photoreaktivität von Gemischen, die olefinisch ungesättigte Polymere und — als Photoinitiatoren — Azide enthalten, weiter zu erhöhen, um auf diese Weise die phototechnische Herstellung von Reliefstrukturen noch rationeller zu gestalten.

Dies wird erfindungsgemäß dadurch erreicht, daß als Photoinitiatoren N-Azidoaryl-maleinimide, 4-Azido-4'-maleinimido-diphenyläther oder N-Azidosulfonylaryl-maleinimide und als Polymere acrylat- und/oder methacrylatgruppenhaltige Polymere, Diallylphthalat-Prepolymere, Polycinnamate und Polyisoprenharze, gegebenenfalls in Gegenwart eines Sensibilisators, eingesetzt werden.

Unter »N-Azidoaryl-maleinimiden« werden im Rahmen der vorliegenden Patentanmeldung Verbindungen verstanden, bei denen sich zwischen der Azidogruppe und der Maleinimidgruppe eine Aryl-Gruppierung befindet. Mit dem Begriff »Aryl« werden dabei Benzolderivate bezeichnet, einschließlich anellierter, d. h. kondensierter Ringsysteme.

Das erfindungsgemäße Verfahren gestattet die rationelle Erzeugung organischer Reliefstrukturen

durch kurzzeitige selektive Bestrahlung von Filmschichten und nachfolgendes Herauslösen der unbelichteten Filmteile. Dies ist deshalb möglich, weil die olefinisch ungesättigten Polymeren durch den Zusatz der speziellen Photoinitiatoren photoreaktiver werden.

Als Photoinitiatoren können beim erfindungsgemäßen Verfahren beispielsweise folgende Verbindungen verwendet werden: 3- bzw. 4-Azidophenylmaleinimid, 3-Azido-3'-maleinimido-diphenylmethan bzw. die entsprechende 4,4'-Verbindung und 4-Azido-4'-maleinimido-diphenyläther. Vorzugsweise werden bei diesem Verfahren Azidosulfonylarylmaleinimide verwendet, beispielsweise Azidosulfonylphenylmaleinimid und 2-(N-Maleinimido)-naphthyl-5-sulfonylazid. Derartige Verbindungen, die in der gleichzeitig eingereichten europäischen Patentanmeldung Nr. 80 102 258.3, »N-Azidosulfonylarylmaleinimide sowie deren Verwendung«, beschrieben sind, sind thermisch stabil und ermöglichen somit einen weiten Verarbeitungsspielraum.

Dem photoreaktiven Gemisch können, wie bereits erwähnt, vorteilhaft Sensibilisatoren, wie Michlers Keton, zugesetzt werden. Auf diese Weise wird die Lichtempfindlichkeit des Gemisches noch weiter erhöht. Als olefinisch ungesättigte Polymere können beim erfindungsgemäßen Verfahren, wie bereits ausgeführt, Diallylphthalat-Prepolymere, Polycinnamate und Polyisoprenharze verwendet werden, insbesondere finden aber acrylat- und/oder methacrylatgruppenhaltige Polymere Verwendung.

Anhand von Beispielen soll die Erfindung noch näher erläutert werden.

## Beispiel 1

(Vergleichsversuch)

Aus Pyromellithsäuredianhydrid, Methacrylsäure-2-hydroxyäthylester und 4,4'-Diaminodiphenyläther wird — gemäß DE-C-2 437 348 — eine lösliche polymere Vorstufe in Form eines Polyamidocarbonsäuremethacrylats folgender Struktur

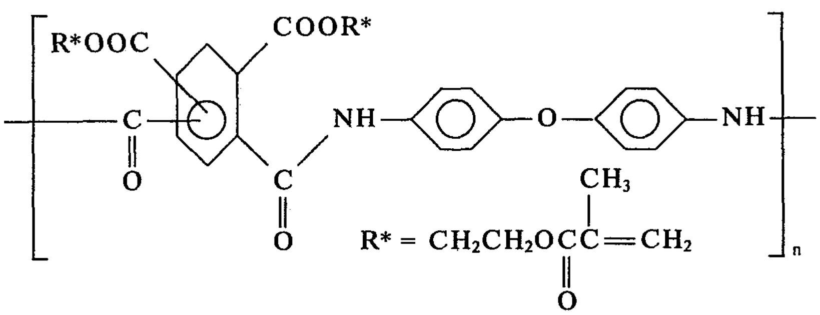

hergestellt (Methacrylatharz).

10 Gewichtsteile des Methacrylatharzes werden zusammen mit 0,5 Gewichtsteilen N-Phenylmaleinimid und 0,2 Gewichtsteilen Michlers Keton in 22 Volumenteilen eines Gemisches von Dimethylacetamid und Dioxan (Volumenverhältnis 1 : 1) gelöst. Die Lösung wird dann filtriert und auf Aluminiumfolien zu gleichmäßigen Filmen geschleudert. Nach 1½stündiger Trocknung bei 60°C im Vakuum beträgt die Filmstärke 6 µm. Die auf diese Weise erhaltenen Filme werden dann mit einer 500-W-Quecksilberhöchstdrucklampe durch eine Kontaktkopie belichtet. Bei einer Belichtungszeit von 60 bis 75 s werden — nach der Entwicklung mit einem 1 : 1-Gemisch von $\gamma$-Butyrolacton und Toluol (Entwicklungsdauer 16 s) — kantenscharfe Reliefstrukturen mit einer Auflösung von 10 µm erhalten. Diese Muster werden eine Stunde bei 340°C getempert, wobei das Auflösungsvermögen und die Kantenschärfe der Reliefstrukturen nicht beeinträchtigt werden.

## Beispiel 2

10 Gewichtsteile des im Beispiel 1 beschriebenen Methacrylatharzes werden zusammen mit 0,2 Gewichtsteilen Azidosulfonylphenylmaleinimid und 0,2 Gewichtsteilen Michlers Keton entsprechend Beispiel 1 zur Herstellung von Filmen mit einer Dicke von 6 µm eingesetzt. Mit derartigen Filmen werden bereits nach einer Belichtungszeit von 30 s, bei den in Beispiel 1 angegebenen Belichtungs- und Entwicklungsbedingungen, kantenscharfe Reliefstrukturen erhalten.

Beispiel 3

(Vergleichsversuch)

10 Gewichtsteile eines handelsüblichen Diallylphthalat-Prepolymeren werden zusammen mit 0,75 Gewichtsteilen N-Phenylmaleinimid und 0,1 Gewichtsteilen Michlers Keton in 20 Volumenteilen eines Gemisches von Dimethylacetamid und Dioxan (Volumenverhältnis 1 : 1) gelöst. Die Lösung wird dann filtriert und auf Aluminiumfolien zu gleichmäßigen Filmen geschleudert. Nach der Entfernung der Lösungsmittel im Vakuum beträgt die Filmstärke 6 µm. Die auf diese Weise erhaltenen Filme werden dann mit einer 500-W-Quecksilberhöchstdrucklampe durch eine Kontaktkopie belichtet. Nach einer Belichtungszeit von 20 bis 30 s werden — nach der Entwicklung mit einem 1 : 1-Gemisch von 1,1,1-Trichloräthan und Trichloräthylen (Entwicklungsdauer 30 s) — kantenscharfe Reliefstrukturen erhalten.

Beispiel 4

10 Gewichtsteile des Diallylphthalat-Prepolymeren nach Beispiel 3 werden zusammen mit 0,2 Gewichtsteilen Azidophenylmaleinimid und 0,1 Gewichtsteilen Michlers Keton entsprechend Beispiel 3 zur Herstellung von Filmen mit einer Dicke von 6 µm eingesetzt. Mit derartigen Filmen werden bereits nach einer Belichtungszeit von 10 s, bei den in Beispiel 3 angegebenen Belichtungs- und Entwicklungsbedingungen, kantenscharfe Reliefstrukturen erhalten.

Beispiel 5

10 Gewichtsteile des Diallylphthalat-Prepolymeren nach Beispiel 3 werden zusammen mit 0,2 Gewichtsteilen Azidosulfonylphenylmaleninimid und 0,1 Gewichtsteilen Michlers Keton entsprechend Beispiel 3 zur Herstellung von Filmen mit einer Dicke von 6 µm eingesetzt. Mit derartigen Filmen werden bereits nach einer Belichtungszeit von 6 s, bei den in Beispiel 3 angegebenen Belichtungs- und Entwicklungsbedingungen, kantenscharfe Reliefstrukturen erhalten.

Beispiel 6

(Vergleichsversuch)

Aus Pyromellithsäuredianhydrid, Allylalkohol und 4,4'-Diaminodiphenyläther wurde — gemäß DE-C-2 308 830 — eine lösliche polymere Vorstufe in Form eines Polyamidocarbonsäureallylesters folgender Struktur

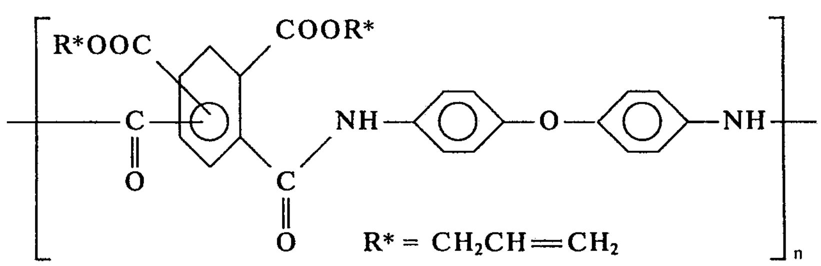

hergestellt (Allylesterharz).

10 Gewichtsteile des Allylesterharzes werden zusammen mit 0,5 Gewichtsteilen N-Phenylmaleinimid und 0,1 Gewichtsteilen Michlers Keton in 40 Volumenteilen Dimethylacetamid gelöst. Die Lösung wird dann filtriert und auf Aluminiumfolien zu Filmen mit einer Stärke von 5 µm geschleudert. Diese Filme werden dann mit einer 500-W-Quecksilberhöchstdrucklampe durch eine Kontaktkopie 11 min lang belichtet und danach 30 s mit $\gamma$-Butyrolacton entwickelt. Dabei werden Strukturen mit einem Auflösungsvermögen von 10 µm erhalten.

Beispiel 7

Mittels einer Reaktionslösung, die 10 Gewichtsteile des Allylesterharzes nach Beispiel 6, 0,1 Gewichtsteile Azidosulfonylphenylmaleinimid und 0,1 Gewichtsteile Michlers Keton enthält, werden auf Aluminiumfolien 5 µm starke Filme erzeugt. Bei den gleichen Belichtungs- und Entwicklungsbedingungen wie in Beispiel 6 ist lediglich eine Belichtungszeit von 8 min erforderlich, um aus derartigen Filmen kantenscharfe Reliefstrukturen herzustellen.

Beispiel 8

(Vergleichsversuch)

5 Gewichtsteile eines Phenoxyharzpolycinnamates, hergestellt aus einem handelsüblichen Phenoxyharz mit einem Molekulargewicht von 20 000 bis 25 000 durch Veresterung mit Zimtsäurechlorid, werden zusammen mit 0,05 Gewichtsteilen Michlers Keton in 20 Volumenteilen Dioxan gelöst und die Lösung wird auf Aluminiumfolien zu gleichmäßigen Filmen geschleudert. Nach Entfernen des Lösungsmittels beträgt die Filmstärke 7 µm. Die Belichtung mit einer 500-W-Quecksilberhöchstdrucklampe durch eine Kontaktmaske ergibt nach einer Belichtungszeit von 90 s ein mit Toluol in 25 s entwickelbares Bild; die dabei erhaltenen Strukturen haben eine gute Kantenschärfe.

Beispiel 9

Werden der Reaktionslösung nach Beispiel 8 0,2 Gewichtsteile Azidosulfonylphenylmaleinimid zugesetzt, so erhält man bei den dort angegebenen Bedingungen bereits nach einer Belichtungszeit von 10 s kantenscharfe Reliefstrukturen.

**Patentansprüche**

1. Verfahren zur phototechnischen Herstellung von Reliefstrukturen aus Gemischen, welche olefinisch ungesättigte Polymere und Azide als Photoinitiatoren enthalten, dadurch gekennzeichnet, daß als Photoinitiatoren N-Azidoaryl-maleinimide, 4-Azido-4'-maleinimido-diphenyläther oder N-Azidosulfonylaryl-maleinimide und als Polymere acrylat- und/oder methacrylatgruppenhaltige Polymere, Diallylphthalat-Prepolymere, Polycinnamate und Polyisoprenharze, gegebenenfalls in Gegenwart eines Sensibilisators, eingesetzt werden.

2. Verfahren nach Anspruch 1, dadurch gekennzeichnet, daß als Sensibilisator Michlers Keton verwendet wird.

**Claims**

1. A process for the phototechnical production of relief structures from mixtures which contain olefinically unsaturated polymers and azides as photoinitiators, characterised in that N-azidoarylmaleinimides, 4-azido-4'-maleinimidodiphenylether, or N-azidosulphonylarylmaleinimides are used as photoinitiators and polymers which contain acrylate and/or methacrylate groups, diallyl phthalate prepolymers, polycinnamates and polyisoprene resins are used as polymers, if necessary, in the presence of a sensitizer.

2. A process as claimed in Claim 1, characterised in that Michlers's ketone is used as sensitizer.

**Revendications**

1. Procédé de production par la technique photographique de structures en relief en mélanges qui contiennent des polymères à insaturation oléfinique et des azides comme photo-initiateurs, caractérisé en ce qu'il consiste à utiliser, comme photo-initiateurs, des N-azidoarylmaléimides, un éther 4-azido-4'-maléimidodiphénylique ou des N-azidosulfonylarylmaléimides et, comme polymères, des polymères contenant des groupes acrylate et/ou méthacrylate, des prépolymères de phtalate de diallyle, des polycinnamates et des résines de polyisoprène, le cas échéant en présence d'un sensibilisateur.

2. Procédé suivant la revendication 1, caractérisé en ce qu'il consiste à utiliser comme sensibilisateur la cétone de Michler.